# EUROPÄISCHE PATENTSCHRIFT

(11) **EP 1 802 987 B1**
(45) Veröffentlichungstag und Bekanntmachung des Hinweises auf die Patenterteilung: **12.12.2012**
(21) Anmeldenummer: 05792981.2
(22) Anmeldetag: 10.10.2005
(51) Int. Cl.: G01R 31/28, B65G 47/90

(54) **VORRICHTUNG ZUM TEMPERIEREN UND PRÜFEN ELEKTRONISCHER UND/ODER ELEKTROMECHANISCHER BAUTEILE**
DEVICE FOR TESTING AND REGULATING THE TEMPERATURE OF ELECTRONIC AND/OR ELECTROMECHANICAL COMPONENTS
DISPOSITIF POUR LA THERMOREGULATION ET LE TEST DE COMPOSANTS ELECTRONIQUES ET/OU ELECTROMECANIQUES

(30) Priorität: 20.10.2004 DE 102004051302
(43) Veröffentlichungstag der Anmeldung: 04.07.2007
(73) Patentinhaber: IEF Werner GmbH, 78120 Furtwangen (DE)
(72) Erfinder: BÄR, Manfred, 78147 Vöhrenbach (DE)
(74) Vertreter: Patentanwälte Westphal, Mussgnug & Partner
(86) Internationale Anmeldenummer: PCT/EP2005/010887
(87) Internationale Veröffentlichungsnummer: WO 2006/042660

(56) Entgegenhaltungen:
- DE-A1- 19 831 033
- DE-A1- 19 957 792
- DE-A1-102004 026 165
- US-A1- 2002 026 258
- US-A1- 2004 027 147

## Beschreibung

Die Erfindung betrifft eine Vorrichtung zum Temperieren und Prüfen elektronischer und/oder elektromechanischer Bauteile der im Oberbegriff des Anspruchs 1 genannten Art.

Viele Bauteile, insbesondere mit Halbleitern bestückte Bauteile wie ICs, sind häufig nicht nur bei Raumtemperatur sondern auch bei Temperaturen zwischen -50°C und +150°C zu testen.

Für derartige Prüfungen gibt es Klimaschränke bzw. Temperaturkammern, in welchen die Prüflinge auf die erforderliche Temperatur gebracht und mittels einer Handhabungseinrichtung zur Prüfung in eine Prüf- und Kontaktierungsstation eingesetzt werden.

Eine derartige Vorrichtung ist z. E. aus DE 100 03 839 C2 bekannt.

Nachteil aller bisher bekannter Vorrichtungen dieser Art ist, dass die gesamte, relativ große Kammer, in der sich die auf einer Palette oder einem Förderband liegenden Prüflinge, die Handhabungseinrichtung sowie die Prüf- und Kontaktierstation befinden, auf die Prüftemperatur gebracht werden muss.

Abgesehen davon, dass der hierfür erforderliche Energieaufwand groß ist, ist die Prüfung mit einer derartigen Vorrichtung wegen der langen Aufheiz- bzw. Abkühlzeit zeitraubend.

Ein weiterer Nachteil ist, dass sich die Handhabungseinrichtung sowie die Prüf- und Kontaktierstation im temperierten Bereich befinden, was zu Ungenauigkeit oder sonstigen Problemen infolge temperaturbedingter Dehnung bzw. Schrumpfung führt. Auch ist es bei Temperaturen unter 0°C schwierig, die gesamte Kammer vereisungsfrei zu halten, da beim Ein- und Ausbringen der Bauteile in die Kammer Wasserdampf enthaltende Luft eindringt.

Vorrichtungen zum Temperieren und Prüfen von Bauteilen, die sich mit der Beseitigung dieser Nachteile beschäftigen, sind aus DE 199 57 792 A1 und US 2004/0027 147 A1 bekannt.

Der vorliegenden Erfindung liegt die Aufgabe zugrunde, diese Probleme mit einer neu konzipierten Vorrichtung zu beseitigen.

Gelöst ist diese Aufgabe gemäß der Erfindung mit den Merkmalen des Anspruchs 1.

Der Grundgedanke der Erfindung besteht darin, die Temperierkammer der Temperierstation so zu dimensionieren, dass in dieser Kammer nur ein oder nur wenige Prüflinge Platz haben, während zumindest die Förder- und Handhabungseinrichtung sowie die Prüf- und Kontaktierstation außerhalb der Kammer vorgesehen sind.

Nach einem weiteren Vorschlag kontaktiert der Prüfling zur unmittelbaren Wärme- bzw. Kälteübertragung die Innenfläche des Temperiergehäuses, vorzugsweise des Gehäusedeckels, direkt.

Hierdurch wird eine wesentlich raschere Erwärmung bzw. Abkühlung des Prüflings erreicht als durch Konvektion bzw. Wärmestrahlung. Damit werden Messfehler wegen zu frühen Abbruchs der Temperierung vermieden. Auch besteht eine bessere Möglichkeit, den Temperaturgang der Prüflinge während einer kurzen Messperiode zu erfassen.

Bei Realisierung des erfindungsgemäßen Vorschlages kann die einheitliche Temperierkammer bekannter Vorrichtungen durch mehrere kleine, für sich autonome Temperierstationen ersetzt werden.

Hierdurch wird eine weitere Abkürzung des Messvorganges dadurch erreicht, dass die Prüflinge nacheinander in die Temperierstationen eingebracht und aus diesen nach Erreichen der gewünschten Temperatur entnommen werden, worauf sie mittels der vorzugsweise externen Prüf- und Kontaktierstation geprüft werden.

Weitere Merkmale der erfindungsgemäßen Vorrichtung sind Gegenstand der Unteransprüche 2 bis 9.

Vorteilhafterweise besteht jede Temperierstation aus einem Gehäuse und einem dieses verschließenden, abnehmbaren Deckel, der gleichzeitig als Transportträger für die Prüflinge dient.

Hierbei wirkt der Deckel wegen seiner wesentlich größeren Wärmekapazität gleichzeitig als Temperaturspeicher, sodass bei Überführung des Prüflings aus der Temperaturstation zur Prüf- und Kontaktierstation die Temperatur des Prüflings weitgehend konstant gehalten wird.

Da das Volumen der Temperierkammer vergleichsweise klein ist, wird der Prüfling in kurzer Zeit auf die Prüftemperatur gebracht.

Nach erfolgter Prüfung wird der Prüfling in Qualitätsklassen abgelegt, worauf ein neuer Prüfling in die jeweilige Temperierstation eingesetzt werden kann.

Der Vorteil der erfindungsgemäßen Vorrichtung gegenüber den bekannten Vorrichtungen dieser Art besteht darin, dass jeweils nur eine sehr kleine Temperierstation auf die Prüftemperatur gebracht werden muss. Da das Volumen der Temperierkammer sowie des Prüflings gegenüber dem Gehäuse der Temperiereinrichtung klein ist, nimmt der den Gehäusedeckel kontaktierende Prüfling rasch die Prüftemperatur an, wobei die Temperatur des Gehäuses beim Prüflingswechsel vergleichsweise konstant bleibt. Hierdurch wird der Prüfvorgang beschleunigt und der Energieverbrauch entscheidend gesenkt. Da die Förder- und Handhabungseinrichtungen sowie die Prüf- und Kontaktierstation bei Raumtemperatur arbeiten, sind temperaturbedingte Probleme weitgehend vermieden. Schließlich ist die Gefahr der Vereisung innerhalb der Temperierstation weitgehend vermieden. Tritt dennoch eine Vereisung in einer Station auf, kann diese durch Aufheizen und erforderlichenfalls Einblasen trockener Luft rasch enteist werden, ohne dass hierbei die Gesamtanlage stillgesetzt werden muss.

Die Anzahl der Temperierstationen richtet sich nach dem erforderlichen Durchsatz bzw. ergibt sich aus der benötigten Temperier- und Testzeit.

Die Erfindung ist nachstehend anhand eines bevorzugten Ausführungsbeispieles, das in den Zeichnungen dargestellt ist, im Einzelnen erläutert.

In den Zeichnungen zeigen
- Fig. 1: eine schematische Seitenansicht einer vollständigen Vorrichtung zum Temperieren und Prüfen elektronischer Bauteile,
- Fig. 2: Aufsicht auf die Vorrichtung gemäß Fig. 1 bei nach oben offenem Gehäuse,
- Fig. 3: perspektivische Darstellung einer erfindungsgemäßen Temperierstation,
- Fig. 4: teilweise geschnittene Seitenansicht der Temperierstation gemäß Fig. 3,
- Fig. 5: Schnitt längs der Linie A-A in Fig. 4 und
- Fig. 6: Schnitt längs der Linie B-B in Fig. 4.

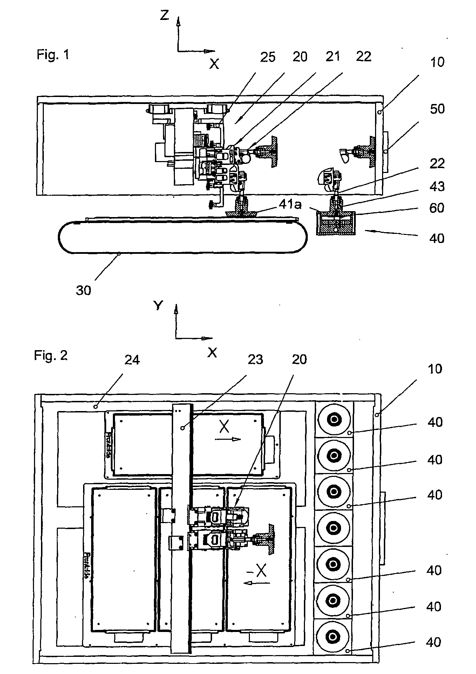

Mit den Figuren 1 und 2 ist die gesamte Vorrichtung zum Temperieren und Prüfen elektronischer Bauteile dargestellt.

Auf einem im Uhrzeigersinn umlaufenden Transportband 30 liegen die Prüflinge, z. B. ICs, auf.

Diese werden mittels einer Handhabungseinrichtung 20 abgenommen und in die Temperierstation 40 eingebracht. Als Transportträger für die Prüflinge dient der Gehäusedeckel 41a der Temperierstation 40, an dessen Unterseite der Prüfling 60 zum Beispiel mittels eines Saugkopfes 44 gehalten wird. Der Gehäusedeckel 41a ist auf seiner Oberseite mit einem Schnellwechseladapter 43 versehen, in welchen ein Greiferstift 22 des Handhabungskopfes 21 eingreifen kann.

Der Handhabungskopf 21 ist an Führungsschienen 23, 24 und 25 in X-, Y- und Z-Richtung verfahrbar und der verdreh- und verschwenkbare Greiferstift 22 mindestens um 90° verschwenkbar. Damit ist es möglich, mittels der Handhabungsvorrichtung 20 den den Prüfling 60 tragenden Deckel 41a vom Transportband 30 abzunehmen, in die Temperierstation 40 einzusetzen, aus dieser wieder zu entnehmen und zu Mess- und Prüfzwecken in die Prüf- und Kontaktierstation 50 einzubringen.

Wie die Aufsicht in Fig. 2 erkennen lässt, sind in einer Reihe nebeneinander mehrere, im Beispiel sieben, Temperierstationen 40 vorgesehen, welche nacheinander von der Handhabungseinrichtung 20 bedient werden.

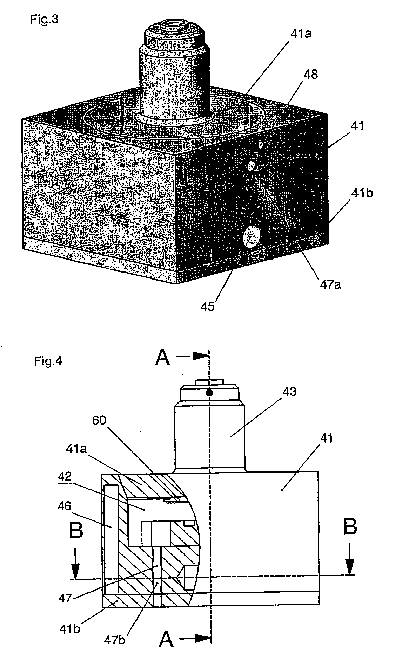

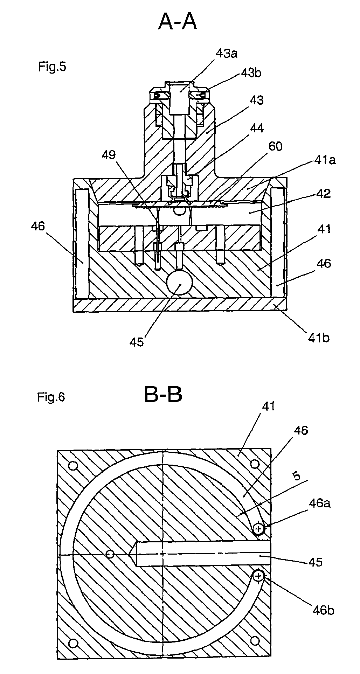

Der genaue Aufbau der Temperierstation 40 ist aus den Figuren 3 bis 6 ersichtlich.

Sie besteht aus einem nach oben offenen, unten mit einem Gehäuseboden 41b verschlossenen Gehäuse 41. Die sich konisch erweiternde Gehäuseöffnung ist mit einem im Querschnitt gleichfalls konischen Deckel 41a verschließbar. Gehäuse 41 und Gehäusedeckel 41a begrenzen die Temperierkammer 42.

An der der Kammer 42 zugewandten Innenseite des Gehäusedeckels 41a ist der Prüfling 60 angebracht, der beim Ausführungsbeispiel mittels von einem Saugkopf 44 erzeugten Unterdruck gehalten wird. Um eine sichere Positionierung und damit auch einen guten Wärme- bzw. Kälteübergang zu erreichen, wird der Prüfling 60 mit Hilfe gefederter Positionierstifte 49 bei Einsetzen des Deckels 41a in das Gehäuse 41 gegen die Deckelunterseite gedrückt. Die Prüftemperatur wird mittels des in den Ringkanal 46, der einen Einlass 46a und einen Auslass 46b besitzt, eingebrachten Kühlmittels sowie einer in die Aufnahme 45 einzusetzenden Heizpatrone erzeugt. Überwacht wird die Kammertemperatur mittels eines in der Kammer 42 endenden Temperatursensors 48.

Da, wie einleitend erwähnt, der Deckel 41a gleichzeitig Transportträger für den Prüfling 60 ist, ist dieser mit einem nach oben abstehenden Kupplungsansatz 43 ausgestattet, in deren Kupplungsaufnahme 43a der Greiferstift 22 des Handhabungskopfes 21 eingreift und mit Hilfe von Arretierstiften 43b gekuppelt wird.

Schließlich münden in die Kammer 42 Luftkanäle 47, in deren Einlass 47a Trockenluft zu Trocknungszwecken eingeblasen werden kann, die über den Auslass 47b austreten kann.

### Bezugszeichenliste

- 10: Gehäuse
- 20: Handhabungseinrichtung
- 21: Handhabungskopf
- 22: Greiferstift
- 23: Führungsschiene
- 24: Führungsschiene
- 25: Führungsschiene
- 30: Transportband
- 40: Temperierstation
- 41: Temperiergehäuse
- 41a: Gehäusedeckel
- 41b: Gehäuseboden
- 42: Kammer
- 43: Schnellwechseladapter
- 43a: Kupplungsaufnahme
- 43b: Arretierbolzen
- 44: Saugkopf
- 45: Aufnahme für Heizpatrone
- 46: Ringkanal
- 46a: Einlass
- 46b: Auslass
- 47: Luftkanal
- 47a: Einlass
- 47b: Auslass
- 48: Temperatursensor
- 49: Positionierstift
- 50: Prüf- und Kontaktierstation
- 60: Prüfling

## Patentansprüche

1. Vorrichtung zum Temperieren und Prüfen elektronischer und/oder elektromechanischer Prüflinge (60), bestehend aus mehreren jeweils eine Heiz- und Kühleinrichtung (45, 46) aufweisenden Temperierstationen (40) mit einer nur einen Prüfling (60) oder nur wenige Prüflinge (60) aufnehmenden Kammer (42), einer Prüf- und Kontaktierstation (50), einer Fördereinrichtung (30) zum Transport der Prüflinge (60) sowie einer Handhabungseinrichtung (20) zum Heranführen und Abtransport der Prüflinge (60) zur bwz. von der Prüf- und Kontaktierstation (50), wobei die Förder- und Handhabungseinrichtung (30) sowie die Prüf- und Kontaktierstation (50) außerhalb der Kammer (42) vorgesehen sind,
**dadurch gekennzeichnet, dass** die Temperierstation (40) jeweils aus einem Gehäuse (41) und einem dieses verschließenden, abnehmbaren Deckel (41a) besteht, dessen Innenfläche der zumindest eine Prüfling (60) zur unmittelbaren Wärme- bzw. Kälteübertragung kontaktiert; dass der Deckel (41a) als Transportträger der Prüflinge (60) dient und das Volumen des Gehäuses gross genenüber dem der aufnehmenden Kammer ist und dass der Deckel (41a) einen Schnellwechseladapter (43) aufweist, welcher mit einem Greifer (22) der Handhabungseinrichtung (20) verbindbar ist

2. Vorrichtung nach Anspruch 1,
**dadurch gekennzeichnet, dass**
das Gehäuse (41) eine sich konisch erweiternde Öffnung aufweist, in welche der im Querschnitt konische Deckel (41a) von oben einsetzbar ist.

3. Vorrichtung nach Anspruch 1 oder 2,
**dadurch gekennzeichnet, dass**
der Prüflinge (60) an der der Kammer (42) zugewandten Fläche des Deckels (41a) mittels eines Saugkopfes (44) anbringbar ist.

4. Vorrichtung nach Anspruch 1, 2 oder 3,
**dadurch gekennzeichnet, dass**
innerhalb der Kammer (42) vorzugsweise abgefederte Positionierstifte (49) vorgesehen sind, welche den Prüfling (60) bei eingesetztem Deckel (41a) gegen dessen Unterseite drücken und mit dem Deckel (41a) in wärmeleitenden Kontakt halten.

5. Vorrichtung nach einem der Ansprüche 1 bis 4,
**dadurch gekennzeichnet, dass**
innerhalb des Gehäuses (41) Kühlmittel- sowie Heizmittelkanäle (45, 46) vorgesehen sind.

6. Vorrichtung nach einem der Ansprüche 1 bis 5,
**dadurch gekennzeichnet, dass**
in die Kammer (42) Luftkanäle (47) zum Einleiten trockener Luft münden.

7. Vorrichtung nach einem der Ansprüche 1 bis 6,
**dadurch gekennzeichnet, dass**
im Gehäuse (41) ein mit der Kammer (42) in Verbindung stehender Temperatursensor (48) angeordnet ist.

8. Vorrichtung nach einem der Ansprüche 1 oder 7,
**dadurch gekennzeichnet, dass**
die Handhabungseinrichtung (20) und die Prüf- und Kontaktierstation (50) in einem nach unten offenen Gehäuse (10) angeordnet sind, unterhalb welchem ein Transportband (30) für den Transport der Prüflinge (60) vorgesehen ist.

9. Vorrichtung nach einem der Ansprüche 1 bis 8,
**dadurch gekennzeichnet, dass**
die Handhabungseinrichtung (20) einen Handhabungskopf (21) mit dem Greifer (22) aufweiset, wobei der Handhabungskopf auf Führungsschienen (23, 24, 25) in X-, Y- und Z-Richtung verfahrbar ist und dessen Greifer (22) verschwenk- und verdrehbar ist.

## Claims

1. Device for tempering and testing electronic and/or electromechanical specimens (60), comprising several tempering stations (40) each having a heating and cooling device (45, 46), with a chamber (42) receiving only one specimen (60) or only a few specimens (60), a testing and contacting station (50), a conveyor device (30) to transport the specimens (60) and a handling device (20) for delivery and discharge of the specimens (60) to and from the test and contacting station (50), wherein the transport and handling device (30) and the test and contacting station (50) are provided outside the chamber (42), **characterised in that** the tempering station (40) consists in each case of a housing (41) and a removable cover (41 a) enclosing this, the inner face of which contacts the at least one specimen (60) for direct heat or cold transmission; that the cover (41a) serves as a transport carrier of the specimens (60) and the volume of the housing is large in comparison with that of the receiving chamber, and that the cover (41 a) comprises a fast-change adapter (43) which can be connected with a gripper (22) of the handling device (20).

2. Device according to claim 1, **characterised in that** the housing (41) comprises a conically expanding opening into which the cover (41 a), which is conical in cross-section, can be inserted from above.

3. Device according to claim 1 or 2, **characterised in that** the specimen (60) can be brought onto the face of the cover (41 a) facing the chamber (42) by means of a suction head (44).

4. Device according to claim 1, 2 or 3, **characterised in that** within the chamber (42) are provided preferably sprung positioning pins (49) which, when the cover (41 a) is applied, press the specimen (60) against its underside and hold it in heat-conductive contact with the cover (41 a).

5. Device according to any of claims 1 to 4, **characterised in that** within the housing (41) are provided coolant and heating medium channels (45, 46).

6. Device according to any of claims 1 to 5, **characterised in that** air channels (47) open into the chamber (42) to introduce dry air.

7. Device according to any of claims 1 to 6, **characterised in that** in the housing (41) is arranged a temperature sensor (48) which is in contact with the chamber (42).

8. Device according to one of claims 1 or 7, **characterised in that** the handling device (20) and the test and contacting station (50) are arranged in a housing (10) open to the underside, below which is provided a conveyor belt (30) for the transport of specimens (60).

9. Device according to any of claims 1 to 8, **characterised in that** the handling device (20) comprises a handling head (21) with gripper (22), wherein the handling head can be moved on guide rails (23, 24, 25) in the X, Y and Z directions and its gripper (22) can be swivelled and twisted.

## Revendications

1. Dispositif pour équilibrer en température et contrôler des échantillons électroniques et/ou électromécaniques (60) constitués par plusieurs postes d'équilibrage en température (40) équipé chacun d'un dispositif de chauffage et de refroidissement (45, 46) comportant une chambre (42) ne recevant qu'un seul ou qu'un faible nombre d'échantillons (60), un poste de contrôle et de mise en contact (50), un dispositif de transport (30) pour le transport des échantillons (60) ainsi qu'un dispositif de manipulation (20) pour permettre de transférer les échantillons (60) vers le poste de contrôle et de mise en contact (50) ou les en extraire, le dispositif de transport et de manipulation (30) ainsi que le poste de contrôle et de mise en contact (50) étant situés à l'extérieur de la chambre (42),
**caractérisé en ce que**
chacun des postes d'équilibrage en température (40) est respectivement constitué d'un boitier (41) et d'un couvercle amovible (41a) fermant ce boitier, dont la surface interne est en contact avec au moins un échantillon (60) pour lui transférer directement de la chaleur ou des frigories, le couvercle (41a) fait office de support de transport des échantillons (60) et le volume du boitier est important par rapport à celui de la chambre de réception, et
le couvercle (41a) est équipé d'un adaptateur à serrage rapide (43) pouvant être relié à un organe de saisie (22) du dispositif de manipulation (20).

2. Dispositif conforme à la revendication 1,
**caractérisé en ce que**
le boitier (41) comporte une ouverture s'évasant coniquement dans laquelle le couvercle (41a) qui a une section conique peut être logé par le haut.

3. Dispositif conforme à la revendication 1 ou 2,
**caractérisé en ce que**
l'échantillon (60) peut être appliqué sur la face du couvercle (41a) tournée vers la chambre (42) au moyen d'une tête d'aspiration (44).

4. Dispositif conforme à la revendication 1, 2 ou 3,
**caractérisé en ce qu'**
à la partie interne de la chambre (42) sont montées des broches de positionnement (49) de préférence soumises à l'action de ressorts qui compriment l'échantillon (60) contre la face inférieure du couvercle (41a) lorsque celui-ci est mis en place, et qui le maintiennent en contact thermique avec ce couvercle (41a).

5. Dispositif conforme à l'une des revendications 1 à 4,
**caractérisé en ce que**
des canaux de circulation d'agent réfrigérant et d'agent chauffant (45, 46) sont montés à la partie interne du boitier (41).

6. Dispositif conforme à l'une des revendications 1 à 5,
**caractérisé en ce que**
des canaux d'air (47) permettant l'introduction d'air sec sont montés dans la chambre (42).

7. Dispositif conforme à l'une des revendications 1 à 6,
**caractérisé en ce qu'**
un détecteur de température (48) lié à la chambre (42) est monté dans le boitier (41).

8. Dispositif conforme à l'une des revendications 1 ou 7,
**caractérisé en ce que**
le dispositif de manipulation (20) et le poste de contrôle et de mise en contact (50) sont disposés dans un boitier (10) ouvert vers le bas, sous lequel est monté une bande transporteuse (30) pour le transport des échantillons (60).

9. Dispositif conforme à l'une des revendications 1 à 8,
**caractérisé en ce que**
le dispositif de manipulation (20) comporte une tête de manipulation (21) équipée de l'organe de saisie (22), cette tête de manipulation pouvant être déplacée sur des rails de guidage (23, 24, 25) dans les directions X-Y et Z, et l'organe de saisie (22) étant mobile en pivotement et en rotation.
